# EUROPÄISCHE PATENTSCHRIFT

(11) **EP 3 448 140 B1**
(45) Veröffentlichungstag und Bekanntmachung des Hinweises auf die Patenterteilung: **08.12.2021**
(21) Anmeldenummer: 17187633.7
(22) Anmeldetag: 24.08.2017
(51) Int. Cl.: H05K 13/00, G03F 7/20, G01D 5/347, B23Q 1/60, B23Q 1/01, G05B 19/404, G05B 19/402, H05K 3/00, G01D 5/34, H05K 13/04, G05B 19/27

(54) **POSITIONIEREINRICHTUNG IN PORTALBAUWEISE**
POSITIONING DEVICE IN PORTAL DESIGN
DISPOSITIF DE POSITIONNEMENT À PORTIQUE

(43) Veröffentlichungstag der Anmeldung: 27.02.2019
(73) Patentinhaber: ETEL S.A., 2112 Môtiers (CH)
(72) Erfinder: INGRAM, David, 1066 Epalinges (CH); HEINIGER, Laurent, 2000 Neuchâtel (CH)
(74) Vertreter: Pleyer, Hans Anno

(56) Entgegenhaltungen:
- EP-A1- 2 849 011
- DE-A1-102006 024 579
- DE-A1-102008 010 284
- DE-A1-102015 219 810
- US-A1- 2004 178 327

## Beschreibung

### GEBIET DER TECHNIK

Die vorliegende Erfindung betrifft eine Positioniereinrichtung in Portalbauweise, mit zwei parallel verlaufenden, angetriebenen Linearachsen für eine erste Richtung, sowie einem entlang dieser Linearachsen verschiebbaren Querträger, der ein Funktionselement in einer zweiten Richtung verschiebbar hält, so dass das Funktionselement in oder parallel zu einer Ebene zwischen den beiden parallelen Linearachsen positionierbar ist. Die Positioniereinheit umfasst außerdem eine angetriebene Linearachse, mit der das Funktionselement senkrecht zu dieser Ebene verstellbar ist, um beispielsweise eine Platine mit Bauteilen zu bestücken oder zu verdrahten.

Solche Positioniereinrichtungen werden auch als Portalantrieb oder X-Y-Gantry bezeichnet, und finden in vielen Bereichen der Technik Anwendung. Die Bearbeitung von flächigen Substraten wie Wafer oder Platinen ist ein typischer Anwendungsfall für solche Portalantriebe. Durch die fortschreitende Miniaturisierung wird auch hier eine immer bessere Positioniergenauigkeit verlangt.

### STAND DER TECHNIK

In der EP 2066996 B1 ist eine Positioniereinrichtung in Portalbauweise beschrieben, bei der zur genaueren Positionsbestimmung Positionsmesssysteme zum Einsatz kommen, die neben der Position in der eigentlichen Messrichtung entlang einer Linearführung auch kleine Abweichungen der Position in einer Richtung quer dazu erfassen können (also z.B. Führungsfehler). Hierzu dienen Maßstäbe, die neben der eigentlichen Messspur in der Messrichtung auch eine sogenannte Geradheitsspur tragen, an der solche kleinen Abweichungen quer zur Messrichtung abgelesen werden können. Solche Maßstäbe werden auch als 1Dplus - Maßstäbe bezeichnet, weil sie neben der Erfassung einer Messrichtung (1D) noch eine Messung in einer weiteren Richtung erlauben, wenn auch nur kleine Abweichungen in dieser Richtung. Solche Maßstäbe und entsprechende Positionsmesssysteme sind in der Firmenschrift HEIDENHAIN INFO, Electronics, Volume 1, 2009 näher beschrieben. Auch eine Anwendung solcher Maßstäbe an einer Positioniereinrichtung in Portalbauweise ist hier gezeigt.

Ein typischer 1Dplus - Maßstab trägt für die eigentliche Messrichtung eine Inkrementalspur oder allgemeiner eine Messspur, die aus feinen, kurzen Strichen quer zur Messrichtung bestehen kann, die beispielsweise optisch von einem relativ zum Maßstab beweglichen Abtastkopf abgetastet werden. Die Geradheitsspur besteht aus wenigen langen Strichen, die parallel zur eigentlichen Messrichtung (und damit quer zur Richtung der Führungsfehler) neben der Inkrementalspur liegen. Auch diese Geradheitsspur wird vom Abtastkopf abgetastet. Durch die Abtastung der Maßstabsspuren entstehen bei einer Relativbewegung zwischen Maßstab und Abtastkopf periodische Signale. Durch Zählen der Perioden und Unterteilen der einzelnen Perioden (Interpolation) kann so das Ausmaß der Verschiebung und damit eine Position festgestellt werden. Von einem 1Dplus - Maßstab können also Positionswerte in zwei voneinander unabhängigen Richtungen abgelesen werden.

Im Stand der Technik sind auch sogenannte Dual-Gantry - Anordnungen bekannt, bei denen zwischen den beiden Linearführungen in der ersten Richtung zwei verschiebbare Querträger angeordnet sind. So beschreibt die WO 02/067648 A1 eine Werkzeugmaschine zur Bearbeitung von Platinen mit gedruckten Schaltungen, die zur Steigerung der Produktivität einen zweiten Querträger mit zusätzlichen Bearbeitungswerkzeugen aufweist.

Aus der EP 2849011 A1 ist eine Dual-Gantry - Anordnung bekannt, bei der der zusätzliche Querträger als Kraftrahmen dient, der hohe Prozesskräfte aufnehmen kann, so dass der erste Querträger ein Funktionselement genauer positionieren kann.

Aus der DE 102008010284 A1 ist ein XY-Tisch bekannt, der mittels einer Gantry-Anordnung positioniert wird. Eine besondere Anordnung der Messsysteme ermöglicht die Einhaltung der Abbe-Bedingung und damit eine genaue Positionierung des Tisches.

Aus der US 2015/0280529 A1, von der die vorliegende Erfindung ausgeht, ist eine Positioniereinrichtung in Portalbauweise bekannt, mit zwei auf einer Basis parallel zueinander angeordneten Linearführungen, die einen ersten Querträger und einen zweiten Querträger in einer ersten Richtung beweglich halten. Am ersten Querträger ist ein Y-Laufwagen mit einem Funktionselement in einer zweiten Richtung beweglich gehalten. Am Y-Laufwagen und am zweiten Querträger sind Positionsmesseinrichtungen zur Messung der Lage des Y-Laufwagens relativ zum zweiten Querträger angeordnet. Indem nun die Lage des Y-Laufwagens relativ zu einem zweiten Querträger gemessen wird, der weder mechanisch noch thermisch beeinflusst wird, der also wesentlich formstabiler ist als der erste, den Y-Laufwagen tragende Querträger, ist eine wesentlich genauere Erfassung der räumlichen Lage des Y-Laufwagens möglich. Mittels zusätzlicher Antriebe zur Feinpositionierung, die zwischen dem Y-Laufwagen und dem Funktionselement wirken, ist somit eine genauere Positionierung des Funktionselements in allen Freiheitsgraden möglich, unabhängig von einer Verformung des ersten Querträgers.

Allerdings kann bei dieser Positioniereinrichtung die Positionierung des Funktionselementes senkrecht zur Basis, die mittels einer weiteren angetriebenen Linearführung bewerkstelligt wird, nicht überwacht werden. Verlagerungen des Angriffspunkts (Tool Center Point, TCP) des Funktionselements parallel zur Ebene der Basis, die bei der senkrechten Bewegung des Funktionselements auftreten, können nicht erfasst und damit auch nicht kompensiert werden.

### ZUSAMMENFASSUNG DER ERFINDUNG

Es ist daher Aufgabe der Erfindung, eine Positioniereinrichtung in Portalbauweise zu schaffen, mit der eine noch genauere Erfassung der Position des Funktionselements und dadurch dessen genaue Positionierung ermöglicht werden.

Diese Aufgabe wird gelöst durch eine Vorrichtung gemäß Anspruch 1. Vorteilhafte Details dieser Vorrichtung ergeben sich aus den von Anspruch 1 abhängigen Ansprüchen.

Es wird eine Positioniereinrichtung in Portalbauweise offenbart, mit zwei auf einer Basis parallel zueinander angeordneten Linearführungen, die einen ersten Querträger und einen zweiten Querträger in einer ersten Richtung beweglich halten, wobei am ersten Querträger ein Y-Laufwagen mit einem Funktionselement in einer zweiten Richtung beweglich gehalten ist, und wobei am zweiten Querträger und am Y-Laufwagen eine Positionsmesseinrichtung zur Erfassung der Lage des Y-Laufwagens relativ zum zweiten Querträger angeordnet ist. Das Funktionselement ist gegenüber dem Y-Laufwagen mittels eine Z-Laufwagens in einer dritten Richtung beweglich gehalten, wobei am Y-Laufwagen und am Funktionselement eine weitere Positionsmesseinrichtung zur Erfassung der Lage des Funktionselements relativ zum Y-Laufwagen angeordnet ist.

Dabei ermöglicht die weitere Positionsmesseinrichtung eine Erfassung der Verlagerung des Funktionselements relativ zum Y-Laufwagen in der ersten und zweiten Richtung.

Das bewährte Konzept eines bewegten Bezugssystems, das frei von Prozesskräften gehalten wird und das genaue Positionsmessungen ermöglicht, wird somit auf eine weitere Messrichtung erweitert. Durch den Verzicht auf eigene Antriebe für den zweiten Querträger wird der Aufbau im Vergleich zum Stand der Technik sogar vereinfacht und kann so kompakt ausgeführt werden, dass auch eine Dual - Gantry Anordnung ermöglicht wird.

Weitere Vorteile und Einzelheiten der vorliegenden Erfindung ergeben sich aus der nachfolgenden Beschreibung verschiedener Ausführungsformen anhand der Figuren.

### KURZE BESCHREIBUNG DER ZEICHNUNGEN

Dabei zeigt
- Figur 1: eine herkömmliche Positioniereinrichtung in Portalbauweise,
- Figur 2: eine erste erfindungsgemäße Positioniereinrichtung in Portalbauweise,
- Figur 3: eine erste Ansicht einer weiteren erfindungsgemäßen Positioniereinrichtung,
- Figur 4: eine zweite Ansicht dieser weiteren erfindungsgemäßen Positioniereinrichtung,
- Figur 5: eine Detailansicht dieser weiteren erfindungsgemäßen Positioniereinrichtung.

### BESCHREIBUNG DER AUSFÜHRUNGSFORMEN

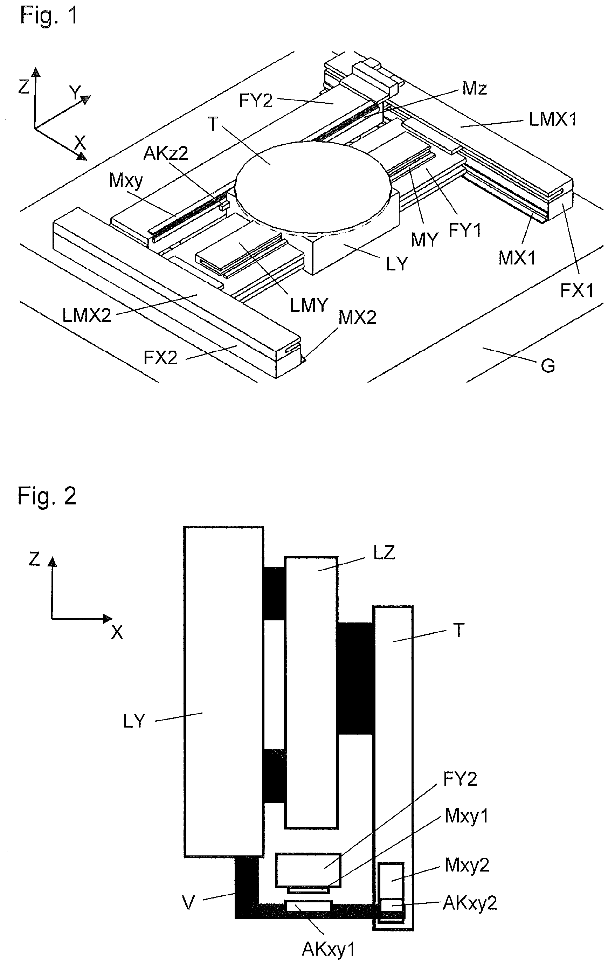

Die Figur 1 zeigt eine aus dem Stand der Technik bekannte Positioniereinrichtung in Portalbauweise. Auf einer zum Beispiel als Granitblock ausgeführten Basis G sind zwei parallele Linearführungen FX1, FX2 angeordnet, die einen Querträger FY1 in X-Richtung verschiebbar halten. Zum Bewegen des Querträgers FY1 dienen zwei Linearmotoren LMX1, LMX2, die parallel zu den Linearführungen FX1, FX2 liegen oder in diese integriert sind. Am Querträger FY1 ist ein Y-Laufwagen LY in Y-Richtung mittels eines weiteren Linearmotors LMY verschiebbar geführt.

Der Y-Laufwagen LY trägt als Beispiel für ein Funktionselement einen Tisch T, auf dem ein Wafer abgelegt werden kann, der dann über ein ortsfest oberhalb der Positioniereinrichtung angeordnetes Werkzeug bearbeitet oder inspiziert werden kann.

Die Positionierung der Linearachsen in X- und Y-Richtung erfolgt anhand von Maßstäben MX1, MX2, MY entlang der jeweiligen Führungen FX1, FX2, FY1, die von hier nicht dargestellten Abtastköpfen abgetastet werden, um die jeweils aktuelle Position aller Achsen zu ermitteln. Über herkömmliche Positionsregler werden alle beweglichen Achsen auf die jeweiligen Positionssollwerte geregelt und so der Tisch T in der X-Y-Ebene positioniert.

Der Y-Laufwagen LY bewegt sich gegenüber dem Querträger FY vor allem in die Y-Richtung, ist aber auch in den Freiheitsgraden Rotation um die X-und Y-Richtung sowie lineare Verschiebung in Z-Richtung beweglich, bedingt durch Führungsfehler und Elastizitäten in den verschiedenen Bauteilen.

Man erkennt außerdem einen zweiten Querträger FY2. Dieser zweite Querträger FY2 verfügt über eigene Antriebe für die X-Richtung, kann also vom ersten Querträger FY1 unabhängig positioniert werden. Er wird jedoch von seinem Positionsregler in einem festen Abstand zum ersten Querträger FY1 gehalten. Dieser Abstand muss so genau eingehalten werden, dass die weiter unten beschriebene Positionsmesseinrichtung zur Erfassung der Lage des Y-Laufwagens LY relativ zum zweiten Querträger FY2 zuverlässig ausgewertet werden kann. Die Abstandstoleranz der Positionsmesseinrichtung, innerhalb der eine Auswertung noch möglich ist, liegt typischerweise bei etwa 200 Mikrometern.

Im Y-Laufwagen LY sind Antriebe untergebracht, die eine Feinpositionierung des Tisches T während der Scan-Bewegung des Y-Laufwagens LY ermöglichen. Diese Feinpositionierung sollte zumindest für die Rotationen um die X- und Y-Achse möglich sein, sowie für die Z-Richtung. Die Positionskorrektur in X und Y, sowie die Rotation um die Z-Achse können auch mit den Antrieben der Positioniereinrichtung in Portalbauweise erfolgen. So können Abweichungen von einer gewünschten Scan-Bewegung in allen sechs Freiheitsgraden korrigiert werden, die zu diesem Zweck jedoch gemessen werden müssen.

Als Bezugssystem für diese Positions- bzw. Lagemessung dient dabei der zweite Querträger FY2, der deswegen hier auch als bewegliches Bezugssystem bezeichnet wird. Der Vorteil dieser Lösung ist, dass durch die Scan-Bewegungen des Y-Laufwagens LY keine Kräfte auf den zweiten Querträger FY2 ausgeübt werden, und auch dass die Antriebe des ersten Querträgers FY1 keine Wärme in den zweiten Querträger FY2 einbringen.

Wartet man eine gewisse Zeit nach jeder Positionsänderung (Step-Bewegung) des ersten und zweiten Querträgers FY1, FY2 ab, so dass Schwingungen des zweiten Querträgers FY2 abgeklungen sind, kann dieser als ortsfest gelten. Da der zweite Querträger FY2 keinen Y-Laufwagen trägt, kann er besonders leicht ausgeführt sein, wodurch seine Resonanzfrequenzen besonders hoch liegen und Schwingungen schnell abklingen.

Stellt man die genaue Lage des zweiten Querträgers FY2 relativ zur Basis G fest (eine mögliche Anordnung von Messsystemen hierzu ist in der eingangs erwähnten US 2015/0280529 A1 beschrieben), eignet er sich während der Scan-Bewegung des Y-Laufwagens LY bzw. des Tisches T als Bezugssystem für die Positionsmessung des Y-Laufwagens LY in allen Freiheitsgraden. Misst man also die Position des Y-Laufwagens LY direkt in Bezug auf den zweiten Querträger FY2 in allen Freiheitsgraden, können Verformungen des ersten Querträgers FY1 (z.B. durch Beschleunigungskräfte, das Gewicht des Y-Laufwagens, Temperatureinflüsse, Schwingungen) erkannt und über die zur Verfügung stehenden Antriebe (der Feinpositionierung des Tisches T und/oder der Achsen der Positioniereinrichtung in Portalbauweise) ausgeregelt werden.

Um wirklich jede Rückwirkung vom ersten Querträger FY1 auf den zweiten Querträger FY2 auszuschließen, sollten Schwingungen der Basis G aktiv gedämpft werden, so dass nicht nur Schwingungen von außen abgeschirmt werden, sondern auch solche, die von den Prozesskräften des ersten Querträgers FY1 und zweiten Querträgers FY2 in die Basis G eingeleitet werden.

Zur Positionsbestimmung des Y-Laufwagens LY relativ zum zweiten Querträger FY2 erkennt man am zweiten Querträger Maßstäbe Mxy, Mz, sowie am Y-Laufwagen einen Abtastkopf AKz2. Weitere Maßstäbe und Abtastköpfe sind in dieser Darstellung nicht zu erkennen, eine Möglichkeit für deren Anordnung ist in der oben zitierten US 2015/0280529 A1 offenbart. Damit es möglich, die Position des Y-Laufwagens LY relativ zum zweiten Querträger FY2 in allen 6 Freiheitsgrade zu ermitteln.

Ein Problem entsteht jedoch dann, wenn in so einer Anordnung zusätzlich das Funktionselement T auch in einer dritten Richtung Z positioniert werden soll. Die Figur 2 erklärt das Problem und dessen Lösung an einem vereinfachten ersten Ausführungsbeispiel der Erfindung. Man erkennt den Y-Laufwagen LY, und einen daran in Z-Richtung geführten Z-Laufwagen LZ. An diesem Z-Laufwagen LZ ist nun möglichst starr das Funktionselement T befestigt. Mit einem Linearantrieb lässt sich so das Funktionselement T auch in der dritten Richtung Z positionieren.

Bei diesem Funktionselement T kann es sich beispielsweise um ein Element zum Positionieren eines Bauteils auf einer auf dem Granit G abgelegten Leiterplatte handeln. Auch diese Z-Achse weist Führungsfehler auf, und sowohl der Y-Laufwagen LY als auch das Funktionselement T und dessen Befestigung sind nicht völlig starr. All diese Effekte können zu einem Versatz des Funktionselementes T in der X- und Y-Richtung führen, der von dessen Position in Z-Richtung abhängen kann.

In der Figur 2 ist schematisch angedeutet, dass ein 1Dplus - Maßstab Mxy1 am zweiten Querträger FY2 von einem über eine starre Verbindung V mit dem Y-Laufwagen LY verbundenen Abtastkopf AKxy1 abgetastet wird. Mit zwei solcher in Y-Richtung hintereinander angeordneten Abtastköpfen AKxy1 lässt sich die Lage des Y-Laufwagens LY relativ zum zweiten Querbalken FY2 bestimmen, und zwar hinsichtlich der X- und Y-Richtung sowie der Rotation um die Z-Richtung. Diese Messung der Relativlage zwischen dem Y-Laufwagen LY und dem zweiten Querbalken FY2 entspricht dem in der Figur 1 dargestellten Stand der Technik.

Um nun zusätzlich auch die bis jetzt unbekannte Verlagerung des Funktionselements T in der X- und Y-Richtung erfassen zu können, sind an der starren Verbindung V mit dem Y-Laufwagen LY außerdem noch zwei Abtastköpfe AKxy2, AKxy2' angeordnet, von denen in der Figur 2 nur einer zu sehen ist. Der zweite Abtastkopf AKxy2' ist in Y-Richtung hinter dem ersten angeordnet. Diese Abtastköpfe AKxy2, AKxy2' tasten zwei 1Dplus - Maßstäbe Mxy2, Mxy2' ab, die in Y-Richtung hintereinander seitlich am Funktionselement T angebracht sind. Diese Kombination von Abtastköpfen AKxy2, AKxy2' und 1Dplus - Maßstäben Mxy2, Mxy2' zu einer weiteren Positionsmesseinrichtung ermöglicht es, den Versatz des Funktionselementes T relativ zum Y-Laufwagen LY nicht nur in der Z-Richtung zu messen, sondern auch in der X- und Y-Richtung, wenn die beiden horizontalen Messungen an den 1Dplus - Maßstäben Mxy2, Mxy2' jeweils Komponenten in beiden Richtungen X, Y erfassen, die geeignet miteinander verrechnet werden. Da außerdem einerseits wie aus dem Stand der Technik bekannt die Relativposition zwischen dem Y-Laufwagen LY und dem zweiten Querbalken FY2 und andererseits die Relativposition des Funktionselements T relativ zum Y-Laufwagen LY bekannt ist, lässt sich auch die Relativposition des Funktionselements T zum zweiten Querbalken FY2 berechnen. Die Position des zweiten Querbalkens FY2 relativ zur Basis G kann sehr genau erfasst werden, so dass die Positionsinformationen relativ zum zweiten Querbalken FY2 auch umgerechnet werden können in ein in der Basis G ruhendes Bezugssystem. Dabei wird von einer sehr starren Verbindung V ausgegangen.

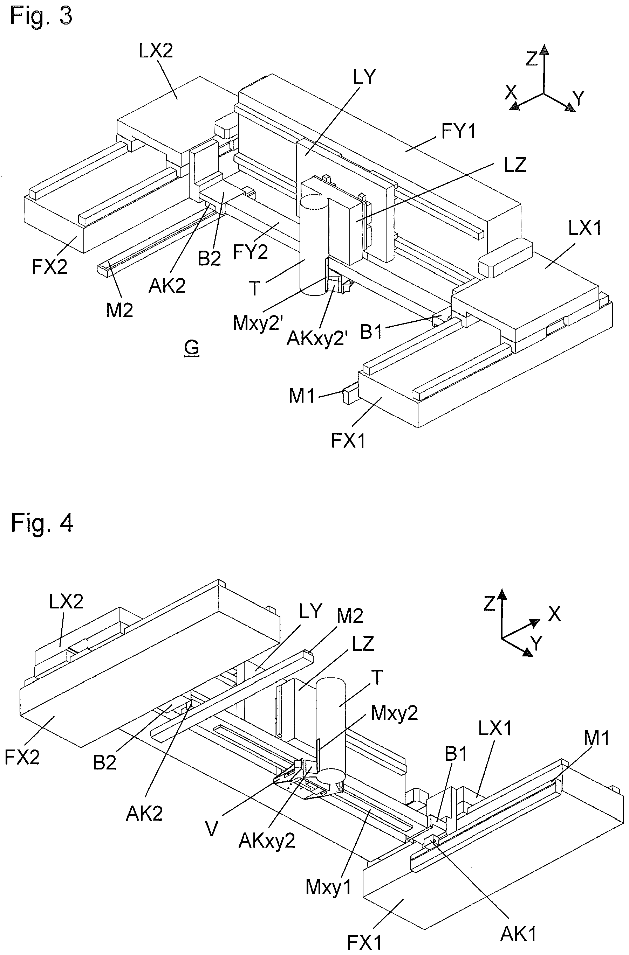

Die Figuren 3 und 4 zeigen ein weiteres und konkretes Ausführungsbeispiel der Erfindung. Die Basis G ist hier weggelassen und nur mit einem Bezugszeichen angedeutet, um die Details der Erfindung und die Unterschiede zum System der Figur 1 besser darstellen zu können.

Man erkennt, dass der zweite Querträger FY2 nun keine eigenen Antriebe mehr aufweist, sondern über Befestigungselemente B1, B2 an den X-Laufwagen LX1, LX2 befestigt ist, und somit von diesen X-Laufwagen LX1, LX2 mitgenommen wird. Da diese X-Laufwagen LX1, LX2 auch den ersten Querträger FY1 bewegen, ist ein annähernd konstanter Abstand zwischen den beiden Querbalken FY1, FY2 gewährleistet.

Der zweite Querbalken FY2 sollte möglichst kräftefrei gehalten werden, damit er sich nicht verbiegt und somit seine Funktion als mitbewegtes Bezugssystem erfüllen kann. Daher sollten die Befestigungselemente B1, B2 flexible Elemente umfassen, die das Gewicht des zweiten Querbalkens tragen können und eine Mitnahme des zweiten Querbalkens FY2 in der ersten Richtung X gewährleisten, die ansonsten aber keine Biegekräfte in den zweiten Querbalken FY2 einleiten. Beispielsweise kann das erste Befestigungselement ein Biegegelenk sein, das alle Freiheitsgrade außer der Rotation um die Z-Richtung sperrt. Das zweite Befestigungselement B2 sollte dann alle Freiheitsgrade außer der Bewegung in Y-Richtung und der Rotation um die Z-Richtung sperren. Dies kann etwa durch eine Kombination eines Biegegelenks mit einem zusammengefalteten Gelenk nach Art eines SCARA-Roboters erreicht werden.

Um für einen größeren Durchsatz Systeme mit zwei ersten Querbalken FY1 und zwei Funktionselementen T bauen zu können, die sich gegenseitig nahe kommen können, ist der zweite Querbalken FY2 nun bezüglich der dritten Richtung Z zwischen der Basis G und dem Verbund aus erstem Querbalken FY1, Y-Laufwagen FY, Z-Laufwagen LZ und Funktionselement T bzw. unterhalb von diesem Verbund angeordnet. Er benötigt also in der ersten Richtung X keinen zusätzlichen Bauraum. Die starre Verbindung V verläuft zwischen der Basis G und dem zweiten Querträger FY. Diese vorteilhafte Anordnung ist auch in der Figur 2 gut zu erkennen. Eine solche Dual-Gantry Anordnung hat dann zwei erste Querbalken FY1 und diesen zugeordnet jeweils einen zweiten Querbalken FY2. Üblicherweise sind die Funktionselemente T in solchen Systemen einander zugewandt. Dank der speziellen Anordnung des zweiten Querbalkens FY2 können sich die beiden Funktionselemente T beinahe beliebig nahe kommen.

Man erkennt in den Figuren 3 und 4 noch Maßstäbe M1, M2, die starr mit der hier nicht dargestellten Basis G verbunden sind. Abtastköpfe AK1, AK2 nahe der Befestigungselemente B1, B2 dienen der Feststellung der Position des zweiten Querbalkens FY2 relativ zur Basis G.

Die Basis G trägt also zwei voneinander getrennte Querbalken FY1, FY2: der erste Querbalken FY1 nimmt dabei alle Prozesskräfte auf und kann sich verbiegen, die entscheidenden Positionsmessungen werden aber (direkt oder wie im Falle des X-Y Versatzes des Funktionselements T indirekt) relativ zum zweiten Querbalken FY2 vorgenommen. Da dessen Position relativ zur Basis G gut bekannt ist, und da sich der zweite Querbalken FY2 auch nicht unter Prozesskräften verbiegt, kann die letztlich entscheidende Position des Funktionselements T relativ zur Basis G festgestellt werden. Dies gilt nun auch für Positionsabweichungen, die durch positionsabhängige Führungsfehler des Z-Laufwagens LZ oder durch Kräfte auf das Funktionselement T bewirkt werden, und die im Stand der Technik nicht erfasst werden konnten.

Somit kann mit dem Funktionselement T eine Bearbeitung eines Objektes vorgenommen werden, dass auf der Basis G abgelegt ist, und zwar an sehr genau definierten Positionen auf dem Objekt.

Gemäß einer Abwandlung zu der in der Figuren 3 und 4 gezeigten Anordnung der Maßstäbe M1, M2 zur Feststellung der Position des zweiten Querbalkens FY2, die dort starr mit der Basis G verbunden sind, können diese Maßstäbe M1, M2 auch auf einem auf der Basis G angeordneten Aufbau angebracht sein, der selber weder starr noch temperaturstabil sein muss. Bei diesem Aufbau kann es sich beispielsweise um ein Handhabungssystem für Objekte wie Wafer oder Platinen handeln. Sind die Maßstäbe M1, M2 auf der Ebene dieser Objekte am Aufbau befestigt, so ist dennoch deren genaue Bearbeitung möglich, da die Position von FY2 nun relativ zu den Maßstäben M1, M2 festgestellt wird, die sich bei einer Deformation des Aufbaus mit dem Objekt mitbewegen.

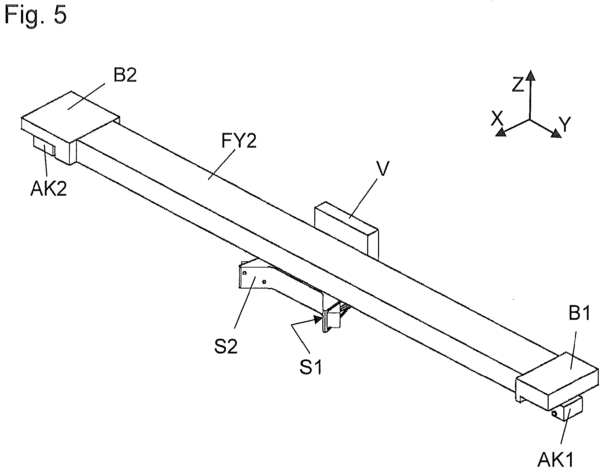

Die Figur 5 zeigt noch eine Detailansicht des zweiten Querbalkens FY2 mit den Befestigungselementen B1, B2 und mit der starren Verbindung V, die ausgehend vom hier nicht dargestellten Y-Laufwagen LY den zweiten Querbalken FY2 umgreift. Am vorderen Ende der starren Verbindung V erkennt man zwei Montageflächen S1, S2, die jeweils unter einem Winkel von 45 Grad zur ersten und zweiten Richtung X, Y ausgerichtet sind, und dabei miteinander einen Winkel von 90 Grad einschließen. An diesen Montageflächen S1, S2 werden die Abtastköpfe AKxy2, AKxy2' montiert, die die beiden 1Dplus - Maßstäbe Mxy2, Mxy2' abtasten, die mit einem Versatz von 90 Grad bezüglich einer Drehung um die dritte Richtung Z am Funktionselement T angebracht sind. Die beiden Abtastköpfe AKxy2, AKxy2' schließen dann ebenfalls einen Winkel von 90 Grad ein und liefern die Position des Funktionselements T relativ zum Y-Laufwagen LY in der dritten Richtung Z, sowie eine Mischung des X- und Y-Versatzes. Diese Mischung kann durch einfache trigonometrische Umformung in den Versatz des Funktionselements T relativ zum Y-Laufwagen LY in die erste Richtung X und die zweite Richtung Y umgerechnet werden. Diese Umformung ist durch die geometrische Anordnung der Maßstäbe Mxy2, Mxy2' und Abtastköpfe AKxy2, AKxy2' bestimmt.

## Patentansprüche

1. Positioniereinrichtung in Portalbauweise, mit zwei auf einer Basis (G) parallel zueinander angeordneten Linearführungen (FX1, FX2), die einen ersten Querträger (FY1) und einen zweiten Querträger (FY2) in einer ersten Richtung (X) beweglich halten, wobei am ersten Querträger (FY1) ein Y-Laufwagen (LY) mit einem Funktionselement (T) in einer zweiten Richtung (Y) beweglich gehalten ist, und wobei am zweiten Querträger (FY2) und am Y-Laufwagen (LY) eine Positionsmesseinrichtung (Mxy, Mz, AKz2, Mxy1, AKxy1) zur Erfassung der Lage des Y-Laufwagens (LY) relativ zum zweiten Querträger (FY2) angeordnet ist, wobei das Funktionselement (T) gegenüber dem Y-Laufwagen (LY) mittels eine Z-Laufwagens (LZ) in einer dritten Richtung (Z) beweglich gehalten ist, wobei am Y-Laufwagen (LY) und am Funktionselement (T) eine weitere Positionsmesseinrichtung (AKxy2, AKxy2', Mxy2, Mxy2') zur Erfassung der Lage des Funktionselements (T) relativ zum Y-Laufwagen (LY) angeordnet ist, und wobei die weitere Positionsmesseinrichtung (AKxy2, AKxy2', Mxy2, Mxy2') eine Erfassung der Verlagerung des Funktionselements (T) relativ zum Y-Laufwagen (LY) in der ersten und zweiten Richtung (X, Y) ermöglicht.

2. Positioniereinrichtung nach Anspruch 1, **dadurch gekennzeichnet, dass** die weitere Positionsmesseinrichtung (AKxy2, AKxy2', Mxy2, Mxy2') zwei 1Dplus - Maßstäbe (Mxy2, Mxy2') umfasst, mit jeweils einer Messspur für die dritte Richtung (Z) und einer Geradheitsspur für die erste und/oder zweite Richtung (X, Y), wobei auf die 1 Dplus - Maßstäbe (Mxy2, Mxy2') jeweils ein Abtastkopf (AKxy2, AKxy2') ausgerichtet ist.

3. Positioniereinrichtung nach Anspruch 2, **dadurch gekennzeichnet, dass** die Geradheitsspuren der 1Dplus - Maßstäbe (Mxy2, Mxy2') sowohl die erste als auch die zweite Richtung (X, Y) unter einem Winkel schneiden, so dass die Verlagerung des Funktionselementes (T) durch Verrechnung der Positionswerte der beiden Abtastköpfe (AKxy2, AKxy2') ermittelbar ist.

4. Positioniereinrichtung nach einem der Ansprüche 2 oder 3, **dadurch gekennzeichnet, dass** die Abtastköpfe (AKxy2, AKxy2') über eine starre Verbindung (V) mit dem Y-Laufwagen (LY) verbunden sind, und dass die 1Dplus - Maßstäbe (Mxy2, Mxy2') am Funktionselement (T) befestigt sind.

5. Positioniereinrichtung nach Anspruch 4, **dadurch gekennzeichnet, dass** die starre Verbindung (V) zusätzlich einen weiteren Abtastkopf (AKxy1) der Positionsmesseinrichtung (Mxy1, AKxy1) zur Erfassung der Lage des Y-Laufwagens (LY) relativ zum zweiten Querträger (FY2) trägt.

6. Positioniereinrichtung nach Anspruch 4 oder 5, **dadurch gekennzeichnet, dass** die starre Verbindung (V) Montageflächen (S1, S2) für die Abtastköpfe (AKxy2, AKxy2') aufweist, wobei die Montageflächen (S1, S2) miteinander einen Winkel von 90 Grad einschließen.

7. Positioniereinrichtung nach einem der Ansprüche 4 - 6, **dadurch gekennzeichnet, dass** die 1Dplus - Maßstäbe (Mxy2, Mxy2') am Funktionsefement (T) um 90 Grad um die dritte Richtung (Z) gegeneinander verdreht angeordnet sind.

8. Positioniereinrichtung nach einem der vorhergehenden Ansprüche, **dadurch gekennzeichnet, dass** der zweite Querträger (LY2) über zwei Befestigungselemente (B1, B2) an zwei X-Laufwagen (LX1, LX2) befestigt ist.

9. Positioniereinrichtung nach Anspruch 8, **dadurch gekennzeichnet, dass** die Befestigungselemente (B1, B2) flexible Elemente umfassen, die das Gewicht des zweiten Querbalkens (FY2) tragen und eine Mitnahme des zweiten Querbalkens (FY2) in der ersten Richtung (X) gewährleisten, die ansonsten aber keine Biegekräfte in den zweiten Querbalken (FY2) einleiten.

10. Positioniereinrichtung nach einem der vorhergehenden Ansprüche, **dadurch gekennzeichnet, dass** der zweite Querträger (FY2) bezüglich der dritten Richtung (Z) unterhalb eines Verbunds aus erstem Querbalken (FY1), Y-Laufwagen (LZ), Z-Laufwagen (LZ) und Funktionselement (T) und oberhalb der Basis (G) angeordnet ist.

11. Positioniereinrichtung nach Anspruch 10, **dadurch gekennzeichnet, dass** die starre Verbindung (V) zwischen der Basis (G) und dem zweiten Querträger (FY2) verläuft,

12. Positioniereinrichtung nach einem der vorhergehenden Ansprüche, **dadurch gekennzeichnet, dass** eine Lagemesseinrichtung die Erfassung der Lage des zweiten Querträgers (FY2) relativ zu einem absoluten Bezugssystem ermöglicht, so dass der zweite Querträger (FY2) als bewegliches Bezugssystem bei der Feststellung der räumlichen Lage des Y-Laufwagens (LY) relativ zum absoluten Bezugssystem dient.

## Claims

1. Positioning device of portal design, having two linear guides (FX1, FX2) that are arranged parallel to one another on a base (G) and hold a first cross member (FY1) and a second cross member (FY2) so as to be movable in a first direction (X), wherein a Y-carriage (LY) having a functional element (T) is held on the first cross member (FY1) so as to be movable in a second direction (Y), and wherein a position measuring device (Mxy, Mz, AKz2, Mxyl, AKxy1) for detecting the position of the Y-carriage (LY) relative to the second cross member (FY2) is arranged on the second cross member (FY2) and on the Y-carriage (LY), wherein the functional element (T) is held so as to be movable in a third direction (Z) with respect to the Y-carriage (LY) by means of a Z-carriage (LZ), wherein a further position measuring device (AKxy2, AKxy2', Mxy2, Mxy2') for detecting the position of the functional element (T) relative to the Y-carriage (LY) is arranged on the Y-carriage (LY) and on the functional element (T), and wherein the further position measuring device (AKxy2, AKxy2', Mxy2, Mxy2') allows the displacement of the functional element (T) in the first and second direction (X, Y) relative to the Y-carriage (LY) to be detected.

2. Positioning device according to Claim 1, **characterized in that** the further position measuring device (AKxy2, AKxy2', Mxy2, Mxy2') comprises two lDplus measuring bars (Mxy2, Mxy2'), each having a measuring track for the third direction (Z) and a straightness track for the first and/or second direction (X, Y), wherein a sensing head (AKxy2, AKxy2') is directed at each of the lDplus measuring bars (Mxy2, Mxy2').

3. Positioning device according to Claim 2, **characterized in that** the straightness tracks of the lDplus measuring bars (Mxy2, Mxy2') intersect both the first and the second direction (X, Y) at an angle such that the displacement of the functional element (T) is able to be determined by offsetting the position values of the two sensing heads (AKxy2, AKxy2') .

4. Positioning device according to either of Claims 2 and 3, **characterized in that** the sensing heads (AKxy2, AKxy2') are connected to the Y-carriage (LY) via a rigid connection (V), and **in that** the lDplus measuring bars (Mxy2, Mxy2') are fastened to the functional element (T).

5. Positioning device according to Claim 4, **characterized in that** the rigid connection (V) additionally carries a further sensing head (AKxy1) of the position measuring device (Mxy1, AKxy1) for detecting the position of the Y-carriage (LY) relative to the second cross member (FY2).

6. Positioning device according to Claim 4 or 5, **characterized in that** the rigid connection (V) has mounting faces (S1, S2) for the sensing heads (AKxy2, AKxy2'), wherein the mounting faces (S1, S2) enclose an angle of 90 degrees with one another.

7. Positioning device according to one of Claims 4-6, **characterized in that** the lDplus measuring bars (Mxy2, Mxy2') are arranged on the functional element (T) in a manner rotated through 90 degrees about the third direction (Z) with respect to one another.

8. Positioning device according to one of the preceding claims, **characterized in that** the second cross member (LY2) is fastened to two X-carriages (LX1, LX2) via two fastening elements (B1, B2).

9. Positioning device according to Claim 8, **characterized in that** the fastening elements (B1, B2) comprise flexible elements that bear the weight of the second crossbeam (FY2) and ensure that the second crossbeam (FY2) is entrained in the first direction (X), but otherwise introduce no bending forces into the second crossbeam (FY2).

10. Positioning device according to one of the preceding claims, **characterized in that** the second cross member (FY2) is arranged, with regard to the third direction (Z), beneath a composite made up of the first crossbeam (FY1), Y-carriage (LZ), Z-carriage (LZ) and functional element (T) and above the base (G) .

11. Positioning device according to Claim 10, **characterized in that** the rigid connection (V) extends between the base (G) and the second cross member (FY2).

12. Positioning device according to one of the preceding claims, **characterized in that** a position measuring device allows the position of the second cross member (FY2) relative to an absolute reference system to be detected, such that the second cross member (FY2) serves as a movable reference system in the establishment of the spatial position of the Y-carriage (LY) relative to the absolute reference system.

## Revendications

1. Dispositif de positionnement à structure en portique comportant deux guides linéaires (FX1, FX2) disposés parallèlement l'un à l'autre sur une base (G), lesquels retiennent de manière déplaçable une première traverse (FY1) et une deuxième traverse (FY2) dans une première direction (X), un chariot Y (LY) doté d'un élément fonctionnel (T) étant retenu sur la première traverse (FY1) de manière déplaçable dans une deuxième direction (Y), et un dispositif de mesure de position (Mxy, Mz, AKz2, Mxy1, AKxy1) servant à la détection de la position du chariot Y (LY) par rapport à la deuxième traverse (FY2) étant disposé sur la deuxième traverse (FY2) et sur le chariot Y (LY), l'élément fonctionnel (T) étant retenu de manière déplaçable dans une troisième direction (Z) par rapport au chariot Y (LY) au moyen d'un chariot Z (LZ), un autre dispositif de mesure de position (AKxy2, AKxy2', Mxy2, Mxy2') servant à la détection de la position de l'élément fonctionnel (T) par rapport au chariot Y (LY) étant disposé sur le chariot Y (LY) et sur l'élément fonctionnel (T), et l'autre dispositif de mesure de position (AKxy2, AKxy2', Mxy2, Mxy2') permettant une détection du décalage de l'élément fonctionnel (T) par rapport au chariot Y (LY) dans la première et la deuxième direction (X, Y).

2. Dispositif de positionnement selon la revendication 1, **caractérisé en ce que** l'autre dispositif de mesure de position (AKxy2, AKxy2', Mxy2, Mxy2') comporte deux règles graduées 1Dplus (Mxy2, Mxy2'), dotées de respectivement une piste de mesure pour la troisième direction (Z) et d'une piste de rectitude pour la première et/ou la deuxième direction (X, Y), une tête de balayage (AKxy2, AKxy2') étant orientée respectivement sur les règles graduées 1Dplus (Mxy2, Mxy2').

3. Dispositif de positionnement selon la revendication 2, **caractérisé en ce que** les pistes de rectitude des règles graduées 1Dplus (Mxy2, Mxy2') croisent à la fois la première et la deuxième direction (X, Y) suivant un angle, de sorte que le décalage de l'élément fonctionnel (T) peut être déterminé par compensation des valeurs de position des deux têtes de balayage (AKxy2, AKxy2').

4. Dispositif de positionnement selon l'une des revendications 2 ou 3, **caractérisé en ce que** les têtes de balayage (AKxy2, AKxy2') sont reliées au chariot Y (LY) par le biais d'une liaison rigide (V), et **en ce que** les règles graduées 1Dplus (Mxy2, Mxy2') sont fixées à l'élément fonctionnel (T).

5. Dispositif de positionnement selon la revendication 4, **caractérisé en ce que** la liaison rigide (V) supporte en outre une autre tête de balayage (AKxy1) du dispositif de mesure de position (Mxy1, AKxy1) servant à la détection de la position du chariot Y (LY) par rapport à la deuxième traverse (FY2).

6. Dispositif de positionnement selon la revendication 4 ou 5, **caractérisé en ce que** la liaison rigide (V) comprend des surfaces de montage (S1, S2) pour les têtes de balayage (AKxy2, AKxy2'), les surfaces de montage (S1, S2) formant l'une avec l'autre un angle de 90 degrés.

7. Dispositif de positionnement selon l'une des revendications 4 à 6, **caractérisé en ce que** les règles graduées 1Dplus (Mxy2, Mxy2') sont disposées sur l'élément fonctionnel (T) de manière tournée l'une par rapport à l'autre de 90 degrés autour de la troisième direction (Z).

8. Dispositif de positionnement selon l'une des revendications précédentes, **caractérisé en ce que** la deuxième traverse (LY2) est fixée à deux chariots X (LX1, LX2) par le biais de deux éléments de fixation (B1, B2).

9. Dispositif de positionnement selon la revendication 8, **caractérisé en ce que** les éléments de fixation (B1, B2) comportent des éléments flexibles qui supportent le poids de la deuxième barre transversale (FY2) et assurent un entraînement de la deuxième barre transversale (FY2) dans la première direction (X), mais qui autrement n'introduisent aucune force de flexion dans la deuxième barre transversale (FY2).

10. Dispositif de positionnement selon l'une des revendications précédentes, **caractérisé en ce que** la deuxième traverse (FY2) est disposée, par rapport à la troisième direction (Z), en dessous d'un ensemble constitué de la première barre transversale (FY1), du chariot Y (LZ), du chariot Z (LZ) et de l'élément fonctionnel (T) et au-dessus de la base (G).

11. Dispositif de positionnement selon la revendication 10, **caractérisé en ce que** la liaison rigide (V) s'étend entre la base (G) et la deuxième traverse (FY2).

12. Dispositif de positionnement selon l'une des revendications précédentes, **caractérisé en ce qu'**un dispositif de mesure de position permet la détection de la position de la deuxième traverse (FY2) par rapport à un système de référence absolu, de sorte que la deuxième traverse (FY2) sert de système de référence mobile lors de la détermination de la position spatiale du chariot Y (LY) par rapport au système de référence absolu.
